Europäisches Patentamt

European Patent Office

Office européen des brevets

(19)

(11) Numéro de publication: **0 326 499**
**A1**

(12) **DEMANDE DE BREVET EUROPEEN**

(21) Numéro de dépôt: 89420017.9

(22) Date de dépôt: 19.01.89

(51) Int. Cl.4: **H 01 L 21/48**

(30) Priorité: 22.01.88 FR 8801136

(43) Date de publication de la demande:
02.08.89 Bulletin 89/31

(84) Etats contractants désignés:
**AT DE ES FR GB IT NL**

(71) Demandeur: PECHINEY RECHERCHE (Groupement d'Intérêt Economique régi par l'ordonnance du 23 Septembre 1967)
23, rue Balzac
F-75008 Paris (FR)

(72) Inventeur: **Oliver, Véronique**
**4, rue de Stockholm**
**F-67000 Strasbourg (FR)**

**Guille, Jean-Louis**
**17, avenue des Vosges**
**F-67000 Strasbourg (FR)**

**Bernier, Jean-Claude**
**11, rue de Lorraine**
**F-67380 Lingolsheim (FR)**

**Drapier, Claude**
**53, route des Puits**
**F-92420 Vaucresson (FR)**

(74) Mandataire: **Séraphin, Léon et al**
**PECHINEY 28, rue de Bonnel**
**F-69433 Lyon Cedex 3 (FR)**

(54) Procédé de cofrittage, de conducteurs en cuivre ou en alliages à base de cuivre et de leur substrat céramique en cordiérite.

(57) L'invention concerne un procédé de cofrittage de conducteurs en cuivre ou en alliage à base de cuivre et d'un substrat céramique, substrat obtenu partir d'une poudre céramique de type cordiérite ayant une température de frittage inférieure à 950°C.

Le procédé comporte les étapes de :

a) mise en forme du substrat céramique à partir d'une poudre de type cordiérite.

b) dépôt de cuivre sur le substrat céramique

c) traitement thermique de cofrittage au cours duquel les composés organiques sont éliminés, le cuivre est régénéré sous atmosphère réductrice, le cofrittage des conducteurs et du susbstrat est réalisé sous flux de gaz inerte humide avec un palier à une température comprise entre 1065 et 1080°C.

Le procédé selon l'invention permet d'obtenir des substrats en cordiérite avec des conducteurs internes et externes.

FIG.1

EP 0 326 499 A1

Description

# PROCEDE DE COFRITTAGE, DE CONDUCTEURS EN CUIVRE OU EN ALLIAGES A BASE DE CUIVRE ET DE LEUR SUBSTRAT CERAMIQUE EN CORDIERITE

## DOMAINE TECHNIQUE DE L'INVENTION

L'invention concerne un procédé de cofrittage de cuivre ou d'alliage bon conducteur de l'électricité, à base de cuivre, et d'un substrat céramique isolant, frittant à basse température (au-dessous de 1100°C), de type cordiérite. Elle s'applique particulièrement mais non exclusivement à la réalisation de circuits électroniques hybrides, circuits d'interconnexions ou boîtiers, mettant en oeuvre les techniques dites à couche épaisse et les multicouches.

## ETAT DE LA TECHNIQUE ANTERIEURE

Il est connu de réaliser des circuits électroniques de puissance sur des substrats céramiques isolants, par exemple en alumine, en assurant l'ancrage des éléments conducteurs sur le substrat céramique par une liaison qui résulte de l'apparition d'un eutectique liquide $Cu - Cu_2O$ (PF 1065°C) mouillant le substrat en alumine, avec lequel il forme probablement une phase spinelle $CuAl_2O_4$ ou un composé $CuAlO_2$ (M. WITTMER, C.R. BOER, P. GUDMUNDSON, J. CARLSON, J. of Am. Ceram. Soc. 65(3) 149-153, 1982).

Il est également connu d'utiliser, comme substrat, des céramiques à base de cordiérite pour la fabrication de substrats isolants, de supports pour les circuits intégrés et de circuits multicouches. Ces céramiques sont préparées par frittage d'une poudre de composition proche de la cordiérite à une température de l'ordre de 1350°C et après addition d'agents de frittage tels que $P_2O_5$. De telles céramiques sont par exemple décrites par K. WATANABE et E. GIESS dans J. of Am. Ceram. Soc. 68 4 C-102 C-103, 1985. On rappelle que la cordiérite a pour formule de base: $2 MgO, 2 Al_2O_3, 5 SiO_2$.

Toutefois, à 1350°C, les métaux conducteurs utilisés habituellement dans les circuits hybrides (cuivre et argent) sont fondus et il est généralement nécessaire d'utiliser des métaux réfractaires ou d'opérer en deux étapes: frittage du substrat céramique à haute température, puis, après refroidissement, application des conducteurs métalliques, par exemple sous forme d'une "encre" obtenue par dispersion de poudre métallique micronique dans un milieu liquide, et nouvelle cuisson à environ 1065/1070°C pour former le composé $Cu/Cu_2O/Al_2O_3$ assurant la liaison cuivre-alumine. Des procédés de ce genre ont été décrits, notamment dans le brevet US 3 994 430 (General Electric Company); le substrat peut être une céramique préalablement frittée, telle que l'alumine (colonne 5, fig. 25) et le conducteur, du cuivre lié à l'alumine dans un deuxième stade par formation d'un eutectique cuivre-oxyde de cuivre. Une application de ce procédé à des boîtiers de semi-conducteurs de puissance, a été décrite dans le brevet US 4 129 243, de la même société.

Dans le brevet US 4 413 061 (I.B.M. Corp.), on propose d'utiliser, comme support pour des circuits multicouches, une "céramique vitreuse", non poreuse, frittable à une température inférieure à 1000°C, choisie parmi le $\beta$-Spodumène et la Cordiérite $\alpha$, dont la vitrification est favorisée par de petites quantités d'additifs tels que $P_2O_5$, $ZrO_2$, $TiO_2$, $SnO_2$, $LiO_2$, $B_2O_3$. Ces ajouts engendrent alors, au cours du frittage, l'apparition de phases qui détériorent en partie les propriétés électriques, thermiques et mécaniques de la céramique.

L'invention se propose de remédier aux inconvénients de ces procédés en réalisant des substrats en cordiérite qui conservent les bonnes caractéristiques électriques et thermiques de ce type de céramique et dont les conducteurs peuvent être cofrittés en même temps que leur support céramique, aussi bien lorsque ces derniers sont positionnés sur la surface extérieure que lorsqu'ils sont interposés entre deux couches isolantes (cas des multicouches).

## OBJET DE L'INVENTION

C'est un procédé de cofrittage d'un métal conducteur non précieux choisi parmi le cuivre et ses alliages (cuivre-nickel par exemple) et d'un substrat en céramique frittable à une température inférieure au point de fusion du métal ou de l'alliage (soit 1083°C dans le cas du Cu pur). L'accrochage des conducteurs sur leur support est nécessaire lorsqu'ils sont placés sur la surface extérieure, c'est-à-dire qu'il doit exister dans ce cas une liaison métal-céramique, mais il peut être avantageux d'éviter cette liaison lorsqu'ils sont en position interne, notamment pour les utilisations en haute fréquence.

Le substrat en céramique choisi pour la mise en oeuvre de l'invention est du type "cordiérite", dont la composition de base est ($2MgO, 2Al_2O_3, 5SiO_2$) obtenue suivant un procédé particulier qui la rend frittable à une température égale ou inférieure à 950°C, sans aucun ajout ni adjuvant de frittage, de composition utilisable pouvant se situer entre $2MgO, 2Al_2O_3, 5SiO_2$ (Cordiérite pure) et $3Al_2O_3, 2SiO_2$ (mullite).

Le métal ou alliage, et notamment le cuivre, est appliqué sous forme d'encre constituée par une poudre fine micronique dispersée dans un milieu liquide. La cordiérite frittable à basse température (< 950°C) est obtenue par exemple selon le procédé décrit dans la demande de brevet français FR-A-2585015 déposée le 16/7/85 au nom du CNRS, l'utilisation comme substrat d'interconnexions ayant, pour sa part, été décrite dans la demande de brevet français FRA-2585181 déposée le même jour, au nom de XERAM, mais dans laquelle les produits envisagés ne comportent pas de conducteurs externes.

## DESCRIPTION DE L'INVENTION

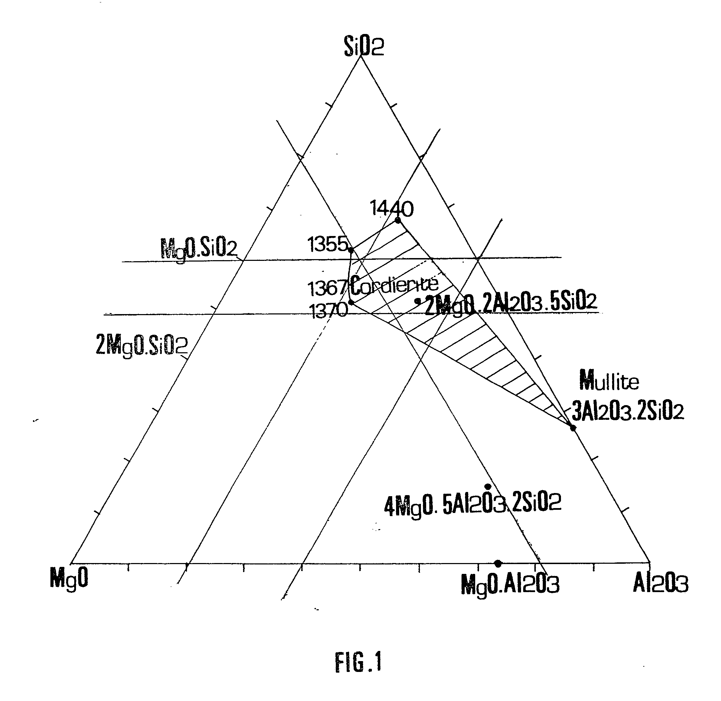

Pour la mise en oeuvre de l'invention, on utilise la poudre obtenue selon la demande de brevet FR-2 585 015, ou toute poudre équivalente possédant les caractéristiques suivantes :
- granulométrie comprise entre 0,5 et 10 micromètres
- structure de type verre non cristallisé
- surface spécifique supérieure à 50 m2/g
- frittage en phase amorphe entre 800 et 950°C; densification d'au moins 95 % après 15 minutes à 1050°C, aboutissant à au moins une phase cristalline
- composition $2Al_2O_3$, $2MgO$, $5SiO_2$ (cordiérite pure) et toute composition comprise entre cordiérite et $3Al_2O_3$, $2SiO_2$ (mullite), correspondant à la zone hachurée dans le diagramme ternaire $Al_2O_3$, $MgO$, $SiO_2$, fig.1.

La mise en forme du substrat peut être effectuée de deux façons :
- on forme le substrat par compression de la poudre sous une pression de l'ordre de 150 MPa (entre 50 et 400 MPa)
- on coule par un procédé type "Doctor Blade" une barbotine de ladite poudre en milieu organique ou aqueux comprenant au moins 35% en poids de poudre minérale, le reste étant composé de solvants, liants, plastifiants et dispersants du type de ceux habituellement utilisés dans ce procédé. On obtient ainsi après évaporation des solvants ou de l'eau une bande d'épaisseur comprise entre 50 et 300 um.

On rappelle que cette méthode est mise en oeuvre dans les conditions suivantes : la barbotine est introduite dans un réservoir dont l'un des côtés peut être déplacé verticalement de manière à former une ouverture calibrée par laquelle la suspension s'écoule. Ce réservoir est placé sur une bande de métal poli ou sur un film polymère (nylon ou polyéthylène par exemple) ou sur une plaque de verre. Le réservoir glisse sur ce support, le mouvement pouvant être obtenu soit par le déplacement du réservoir, soit par le déroulement du support. Le réglage de l'ouverture permet d'obtenir des bandes dont l'épaisseur après séchage est comprise entre 20 et 300 um.

L'encre conductrice à base de cuivre qui est ensuite déposée sur le substrat est principalement constituée
- de pigments pulvérulents contenant du cuivre
- d'une charge de poudre céramique
- d'une phase organique utilisée comme véhicule.
Les pigments contenant du cuivre, qui donneront aux couches après frittage leurs propriétés électriques sont choisis parmi les 3 formules suivantes :
- P1 : poudre de cuivre (ou alliage à base cuivre) non oxydé
- P2 : poudre de cuivre (ou alliage à base de cuivre) partiellement oxydé
- P3 : poudre d'oxydes de cuivre sous l'une des formes $Cu_2O$, $CuO$ ou mélange des 2.

Parmi les alliages à base de cuivre, le cupronickel contenant par exemple de 0,1 à 10% en poids de nickel présente l'avantage de posséder un point de fusion plus élevé que le cuivre pur, ce qui se traduit par un plus grand confort lors du traitement thermique de cofrittage.

Ces poudres contenant du cuivre ayant une morphologie aussi sphérique que possible ont une granulométrie contrôlée telle que la taille moyenne des grains reste comprise entre 2 limites ;
- de 0,1 à 6 um pour les poudres P1 et P2
- de 0,2 à 10 um pour les poudres P3.
La charge de poudre céramique est constituée de cordiérite ayant les mêmes caractéristiques que la poudre utilisée pour le substrat, la quantité introduite étant par exemple comprise entre 0,5 et 20% de la masse de poudre à base de cuivre.

La phase organique qui est composée de solvants, liants, plastifiants et dispersants du type de ceux habituellement utilisés pour les encres conductrices, permet d'atteindre les propriétés rhéologiques nécessaires à l'impression sérigraphique, elle représente de 20 à 55% du poids total de l'encre.

Le procédé de dépôt de l'encre, de préférence de type sérigraphique, ne fait pas partie de l'invention.

Après le dépôt de cuivre, il faut appliquer des traitements thermiques qui conduisent au cofrittage, l'ensemble des paramètres les définissant dépendant de la localisation des conducteurs et de la nature du pigment de l'encre :

a) Lorsque le produit à fabriquer ne présente que des circuits extérieurs, le pigment est choisi parmi les trois formules P1 à P3 ci-dessus et le traitement thermique à mettre en oeuvre est le traitement T1 défini comme suit :
- chauffage à l'air entre 200 et 500°C en vue d'éliminer les composants organiques de l'encre et du substrat par évaporation et combustion; cette phase d'élimination des composés organiques est effectuée dans l'air par montée lente à une vitesse ne dépassant pas 20 K.h $^{-1}$ avec au moins un palier d'une durée au moins égale à 2h à une température comprise entre 200 et 500°C. Cette étape entraîne une oxydation au moins partielle du cuivre métallique présent dans l'encre, principalement à l'état de $CuO$;
- après refroidissement jusqu'à l'ambiante, régénération du cuivre par chauffage sous hydrogène, de préférence avec une vitesse de montée en température comprise entre 100 et 800 K.h$^{-1}$, avec un maintien à la température maximale de traitement (comprise entre 120°C et 350°C) pendant une durée de 10 min à 3 h et avec des paliers intermédiaires éventuels; on peut aussi opérer dans une atmosphère d'hydrogène dilué par un gaz inerte;

- mise sous flux d'argon (ou autre gaz inerte tel que, par exemple, He, $N_2$ )humide (point de rosée 20°C) par barbotage d'argon dans l'eau et montée jusqu'à une température de 1070°C à la vitesse de 720 K.h[1] (de préférence entre 500 et 1000 K.h$^{-1}$); l'addition d'eau dans le gaz inerte peut être remplacée par une faible addition d'oxygène, de l'ordre de quelques ppm en volume, 5 par exemple;
- palier à une température comprise entre 1065 et 1080°C avec un optimum aux environs de 1070°C et pendant une durée comprise entre 15 min et 2 h;
- retour à l'ambiante en 3 h environ (de préférence entre 1h et 4h).

b)Lorsque le produit à fabriquer est un substrat multicouche comportant à la fois des conducteurs internes et externes, le pigment de l'encre est choisi parmi les 3 formules P1 à P3, avec de préférence une encre de formule P3 pour les conducteurs externes et le traitement thermique de type T2 est appliqué comme suit :
- chauffage à l'air entre 200 et 500°C;
- après refroidissement jusqu'à l'ambiante, régénération du cuivre par chauffage sous hydrogène, de préférence avec une vitesse de montée en température comprise entre 100 et 800 K.h$^{-1}$, avec un maintien à la température maximale de traitement pendant une durée de 10 min à 3 h et avec des paliers intermédiaires éventuels; on peut aussi opérer dans une atmosphère d'hydrogène dilué par un gaz inerte;
- mise sous flux d'argon (ou autre gaz inerte) et montée jusqu'à une température de 950°C à la vitesse de 720 K.h$^{-1}$ (de préférence entre 500 et 1000 K.h$^{-1}$);
- palier à la température de 950°C (de préférence entre 900 et 1000°C), pendant une durée comprise entre 15 min et 2 h sous la même atmosphère qu'à la montée;
- mise sous flux de gaz neutre (argon par exemple) et humide (point de rosée 20°C) en fin de palier;
- montée jusqu'à 1070°C sous gaz neutre et humide à une vitesse au moins égale à 500 K.h$^{-1}$;
- palier sous la même atmosphère à une température comprise entre 1065 et 1080°C avec un optimum aux environs de 1070°C et pendant une durée comprise entre 15 min et 2 h;
- retour à l'ambiante en 3 h environ (de préférence entre 1h et 4h).

L'ensemble des solutions décrites ci-dessus sont résumées dans le tableau 1: en même temps qu'une description du procédé, elles représentent des exemples d'application et conduisent toutes à des substrats dont les conducteurs externes sont fortement ancrés à leur support alors que les conducteurs internes ne sont pas liés à la cordiérite, de tels produits étant particulièrement bien adaptés aux utilisations en haute fréquence car :
- l'absence de points de liaison métal-céramique évite l'augmentation d'impédance des conducteurs internes qui ne comportent pas de composés de Cu à leur surface et conservent une rugosité de surface réduite;
- la cordiérite présente une faible constante diélectrique (inférieure à 5);

TABLEAU I

| Produits à réaliser | Type de pigment(encre) | Principaux paramètres des traitements thermiques | | | |
|---|---|---|---|---|---|
| | | Ref. | Nature | Atmosphère | Température °C |
| Substrats ne comportant que des conducteurs externes | P1 P2 P3 | T1 | élimination composés organiques | air | 200 à 500 |
| | | | régénération du Cu | H2 | 120 à 350 |
| | | | cofrittage | air humide | 1065 à 1080 |
| Substrats multicouches avec conducteurs internes et externes | P1 P2 P3 P3 préféré pour conducteur externe | T2 | élimination composés organiques | air | 200 à 500 |
| | | | régénération du Cu | H2 | 120 à 350 |
| | | | oofrittage | Ar | 900 à 1000 |
| | | | | air humide | 1065 à 1080 |

EP 0 326 499 A1

**Revendications**

1. Procédé de cofrittage de conducteurs en cuivre ou en alliage de cuivre et d'un substrat céramique, substrat obtenu à partir d'une poudre céramique de type cordiérite, ayant une température de frittage inférieure à 950°C, une surface spécifique supérieure à 50 m2/g et une composition chimique pouvant se situer entre 2 $Al_2O_3$, 2MgO, $5SiO_2$ (cordiérite pure) et $3Al_2O_3$, 2 $SiO_2$ (mullite), procédé comportant les étapes de :a) mise en forme dudit substrat céramique à partir de ladite poudre

b) dépôt de cuivre sur le substrat céramique par application d'une encre à base de cuivre

c) traitement thermique de cofrittage

et caractérisé en ce que

- l'étape b) de dépôt de cuivre est réalisée à partir d'une encre contenant au moins des pigments pulvérulents à base de cuivre et de la poudre de cordiérite.

- l'étape c) de traitement thermique comporte :

1) une phase d'élimination des composés organiques, présents dans le substrat céramique et/ou dans l'encre, en les décomposant sous atmosphère oxydante à une température ne dépassant pas 500°C.

2) une phase de régénération du cuivre sous atmosphère réductrice.

3) une phase de cofrittage proprement dit, mise en oeuvre en totalité ou en partie sous un flux de gaz inerte humide et comportant un palier à une température comprise entre 1065°C et 1080°C.

2. Procédé selon la revendication 1 dans lequel le cuivre est introduit dans l'encre sous forme d'une poudre à base de cuivre ou d'alliages de cuivre non oxydé.

3. Procédé selon la revendication 1 dans lequel le cuivre est introduit dans l'encre sous forme d'une poudre à base de cuivre ou d'alliage de cuivre partiellement oxydé.

4. Procédé selon la revendication 1 dans lequel le cuivre est introduit dans l'encre sous forme d'une poudre d'oxyde de cuivre de type $Cu_2O$ et/ou CuO ou mélange des 2.

5. Procédé selon l'une quelconque des revendications 2 ou 3 dans lequel la taille granulométrique moyenne de ladite poudre de cuivre est comprise entre 0,1 et 6 um, et de préférence entre 0,2 et 3 um.

6. Procédé selon la revendication 4 dans lequel la taille granulométrique moyenne de ladite poudre d'oxydes de cuivre est comprise entre 0,2 et 10 um, et de préférence entre 0,5 et 6 um.

7. Procédé selon l'une quelconque des revendications 5 ou 6 dans lequel ladite encre contient de la poudre de cordiérite de même nature que celle utilisée pour le substrat et en quantité comprise entre 0,5 et 20% du poids de pigments à base de cuivre, et de préférence entre 1 et 15%.

8. Procédé selon la revendication 7 dans lequel ladite encre contient une quantité de pigments à base de cuivre et de poudre de cordiérite comprise entre 45 et 80% de la masse totale d'encre, et de préférence entre 55 et 70%.

9. Procédé selon les revendications 1 et 8 dans lequel ladite phase d'élimination des composés organiques est effectuée dans l'air par montée lente à une vitesse ne dépassant pas 20 K.h⁻¹ avec au moins un palier d'une durée au moins égale à 2h à une température comprise entre 200 et 500°C.

10. Procédé selon les revendications 1 et 9 dans lequel ladite phase de régénération du cuivre est effectuée sous atmosphère d'hydrogène, pur ou dilué de gaz inerte, à une température comprise entre 120 et 350°C, avec une montée en température comprise entre 100 et 800 k.h⁻¹ et avec un maintien à la température de traitement d'une durée de 10 mn à 3h.

11. Procédé selon les revendications 1 et 10 dans lequel ladite phase de cofrittage proprement dit, mise en oeuvre en totalité ou en partie sous un flux de gaz inerte humide et comportant un palier à une température comprise entre 1065 et 1080°C est effectuée avec une montée en température comprise entre 500 et 1000 K.h⁻¹ et avec un maintien à une température de traitement d'une durée comprise entre 15mn et 2h.

12. Procédé selon la revendication 11 dans lequel ladite phase de cofrittage proprement dit est effectuée sous flux d'argon humide.

13. Procédé selon la revendication 11 dans lequel ledit flux de gaz inerte humide est introduit dès la fin de ladite phase de régénération du cuivre sous atmosphère réductrice.

14. Procédé selon la revendication 11 dans lequel ledit flux de gaz inerte humide n'est introduit qu'à partir de 950°C, l'atmosphère de la phase de cofrittage entre la fin de la phase de régénération et 950°C étant réalisée avec le gaz inerte.

15. Application du procédé selon la revendication 13 à la réalisation de substrats en céramique ne comportant que des conducteurs externes.

16. Application du procédé selon la revendication 14 à la réalisation de substrats multicouches en céramique comportant des conducteurs internes et externes.

FIG.1

Office européen des brevets

# RAPPORT DE RECHERCHE EUROPEENNE

Numero de la demande

EP 89 42 0017

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A,D | FR-A-2 585 181 (INTERCONNEXIONS CERAMIQUES XERAM) * Page 1, lignes 1-12; page 2, ligne 1 - page 3, ligne 3; page 9, ligne 21 - page 10, ligne 6; page 11, lignes 10-21 * | 1-4,10, 11,14, 16 | H 01 L 21/48 |
| A,D | FR-A-2 585 015 (CENTRE NATIONAL DE LA RECHERCHE SCIENTIFIQUE (C.N.R.S.)) * Page 6, ligne 27 - page 8, ligne 9; page 8, ligne 24 - page 9, ligne 9; revendications 1,3 * | 1,2 | |
| A | EP-A-0 219 807 (NARUMI CHINA CORP.) * Résumé; page 4, ligne 23 - page 5, ligne 3; page 9, lignes 7-13; page 9, ligne 26 - page 10, ligne 5 * | 1,2,10 | |
| A | EP-A-0 043 955 (INTERNATIONAL BUSINESS MACHINES) * Page 2, lignes 12-28; page 3, ligne 27 - page 4, ligne 21; revendications 1,2,4 * | 1,2 | |

### DOMAINES TECHNIQUES RECHERCHES (Int. Cl.4)

H 01 L 21/00
H 05 K 1/00
H 05 K 3/00
C 04 B 35/00

Le présent rapport a été établi pour toutes les revendications

| Lieu de la recherche | Date d'achèvement de la recherche | Examinateur |
|---|---|---|
| LA HAYE | 26-04-1989 | DELPORTE B.P.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)